# EUROPÄISCHE PATENTSCHRIFT

(11) **EP 1 042 805 B1**
(45) Veröffentlichungstag und Bekanntmachung des Hinweises auf die Patenterteilung: **10.11.2004**
(21) Anmeldenummer: 98965122.9
(22) Anmeldetag: 15.12.1998
(51) Int. Cl.: H01L 21/8247

(54) **VERFAHREN ZUM HERSTELLEN EINES SPEICHERZELLEN-ARRAYS**
PROCESS FOR PRODUCING A MEMORY CELL ARRAY
PROCEDE DE PRODUCTION D'UN ENSEMBLE DE CELLULES DE MEMOIRE

(30) Priorität: 18.12.1997 DE 19756601
(43) Veröffentlichungstag der Anmeldung: 11.10.2000
(73) Patentinhaber: Infineon Technologies AG, 81669 München (DE)
(72) Erfinder: TEMPEL, Georg, D-85604 Zorneding (DE); KUTTER, Christoph, D-81667 München (DE)
(74) Vertreter: Kindermann, Peter, Dipl.-Ing.
(86) Internationale Anmeldenummer: PCT/DE1998/003673
(87) Internationale Veröffentlichungsnummer: WO 1999/033105

(56) Entgegenhaltungen:
- EP-A- 0 412 558
- JP-A- 9 082 924
- US-A- 5 103 274
- US-A- 5 589 413

## Beschreibung

Die Erfindung betrifft ein Verfahren zum Herstellen eines Speicherzellen-Arrays, insbesondere eines EPROM- bzw. EEPROM-Speicherzellen-Arrays, gemäß dem Oberbegriff des Anspruches 1, welches aus der JP-A-9082924 bekannt ist. Auf dem Gebiet von Speicherzellen-Arrays besteht ein stetiger Bedarf nach einer Reduzierung der Speicherzellenfläche, um eine möglichst hohe Integrationsdichte derartiger Arrays zu gewährleisten.

Eine bekannte Technik zur Speicherzellenflächenreduzierung ist die sogenannte selbstjustierte Source-Konstruktion (Self Aligned Source: SAS), auf die nachfolgend abgekürzt als SAS bezug genommen wird. Diese Technik ist für den Fall von EPROM-Speichern beispielsweise erläutert in Yoichi Ohshima et al., "Process and Device Technologies for 16Mbit EPROMs with Large-Tilt-Angle Implanted p-Pocket Cell", International Electron Device Meeting 1990, Seiten 95 ff. Zur Speicherzellenflächenreduzierung wird demnach mittels einer speziellen Phototechnik (sourceseitig offen) die Isolation, bei der es sich üblicherweise um Feldoxid handelt, zwischen aktiven Gebieten, sogenannten S/D-Gebieten und Wortleitungen mittels Trockenätztechnik (RIE) entfernt, und mit derselben Lackmaske werden Source-Gebiete implantiert.

Eine weitere Anwendung dieser Technik ist in der US-A-5 264 718 für EEPROM-Speicher erläutert, wobei spezielle Maßnahmen getroffen sind, um die ansonsten üblichen hundeknochenförmigen Feldoxidbereiche durch solche mit rechteckigen Konturen zu ersetzen.

In sämtlichen bekannten Fällen wird die vorstehend genannte Technik zur Speicherzellenflächenreduzierung ausschließlich in Kombination mit Feldoxid für die Isolation eingesetzt, da nur so bislang graduelle Übergänge des Substrats zwischen dem Feldoxid und vorher definierten Diffusionsgebieten erzielbar waren. Die Dotierung erfolgt dabei derart, daß das offenliegende Si-Substrat mittels herkömmlicher Hochstrom-Implantation vertikal dotiert wird. Um dabei die Gate-Kanten bei der eigentlichen SAS-Ätzung zu schützen, wird üblicherweise eine Abstandshalter- bzw. Spacertechnik verwendet.

In jüngster zeit kommen vermehrt STI(Shallow Trench Isolation)-Konstruktionen zum Einsatz, wonach sequentiell mittels einer Trench-Ätzung, einem Füllprozeß und einem Rückätz- bzw. Rückpolierprozeß nahezu kastenförmige Isolationsgebiete im SI-Substrat vergraben werden. Setzt man die STI-Technik für die SAS-Technik ein, werden zum Zeitpunkt der Hochstrom-Implantation, die in vertikaler Richtung erfolgt, die senkrechten Seitenwände nicht oder lediglich schwach dotiert. Die Folge ist, daß durch diese Kombination der beiden Techniken nur sehr hochohmige zusammenhängende Source-Gebiete bei der Herstellung von Speicherzellen-Arrays erhalten werden können.

Eine Aufgabe der vorliegenden Erfindung besteht darin, ein Verfahren zum Herstellen eines Speicherzellen-Arrays, der eingangs genannten Art zu schaffen, das gewährleistet, daß für die Speicherzellen-Arrays niederohmige, zusammenhängende Diffusionsbereiche ohne aufwendige Implantation bei gleichzeitiger Integration eines Isolationsoxids erzielbar sind.

Erfindungsgemäß wird diese Aufgabe durch das in Anspruch 1 angegebene Verfahren gelöst.

Vorteilhafte Weiterbildungen der Erfindung sind in den Unteransprüchen angegeben.

Gemäß einer bevorzugten Weiterbildung folgt auf den Enfernungsschritt ein Nachbehandlungsschritt für die freigelegte Struktur.

Gemäß einer weiteren bevorzugten Weiterbildung umfaßt der Ätzschritt zusätzlich ein Überätzen.

Gemäß einer weiteren bevorzugten Weiterbildung werden im Ätzschritt die Hartmaske und das CVD-Oxid bzw. -Nitrid gedünnt.

Gemäß einer weiteren bevorzugten Weiterbildung wird der Temperschritt in einem Ofen durchgeführt.

Gemäß einer weiteren bevorzugten Weiterbildung erfolgt der Temperschritt mittels RTA.

Gemäß einer weiteren bevorzugten Weiterbildung folgt auf den Schritt ein Schritt zum Planarisieren der gewonnenen Struktur.

Gemäß einer weiteren bevorzugten Weiterbildung erfolgt das Planarisieren mittels CMP.

Gemäß einer weiteren bevorzugten Weiterbildung folgt auf das Planarisieren ein Prozeß zur Kontaktlochätzung und -füllung und zur Metallisierung.

Ausführungsbeispiele der Erfindung sind in den Zeichnungen dargestellt und in der nachfolgenden Beschreibung näher erläutert.

Es zeigen:
- Fig. 1: eine schematische Ansicht einer Vorstufe des Speicherzellen-Arrays, in welcher die Wortleitungsstrukturierung erfolgt ist;
- Fig. 2: die Struktur von Fig. 1 nach Durchführung der SAS-Ätzung;
- Fig. 3 bis Fig. 8: die einzelnen Verfahrensschritte des erfindungsgemäßen Verfahrens als Schnittdarstellung entlang der Linie B-B von Fig. 2; und
- Fig. 9: einen Schnitt entlang der Linie A-A von Fig. 2 zur Verdeutlichung der Lage der SAS-Lackmaske innerhalb eines Speicherzellenfelds.

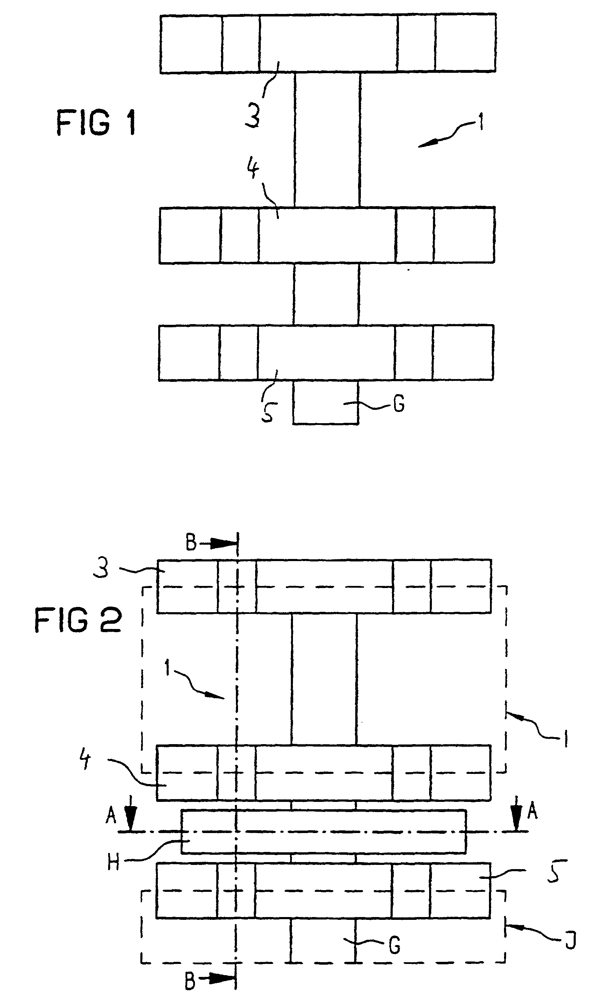

Fig. 1 zeigt eine Draufsicht eines Speicherzellen-Arrays vor Ausbildung des Source-Bereichs, während Fig. 2 eine ähnliche Ansicht, jedoch bei ausgebildetem Source-Bereich zeigt. Mit den Bezugszeichen 3, 4 und 5 sind die Wortleitungsstrukturen bezeichnet, während mit G das Diffusionsgebiet bezeichnet ist. Der Source-Bereich (Self Aligned Source) ist in Fig. 2 mit H bezeichnet, wobei die Lage der nachfolgend im einzelnen erläuterten SAS-Maske punktiert in Fig. 2 dargestellt und mit I und J bezeichnet ist.

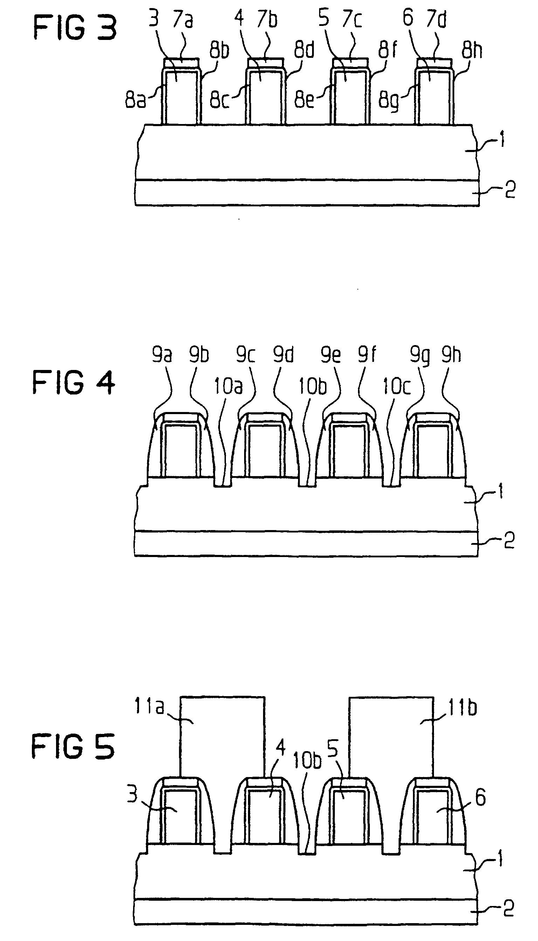

Nachfolgend wird das erfindungsgemäße Verfahren zum Herstellen eines Speicherzellen-Arrays anhand der Figuren 3 bis 8 näher erläutert, die jeweils Schnitte entlang der Linie B-B von Fig. 2 bei den einzelnen Herstellungsschritten sind.

Zunächst werden mit der eingehend erläuterten STI(Shallow Trench Isolation)-Technik-Isolationsgebiete, von den in Fig. 3 bis 9 ein Isolationsgebiet 1 dargestellt ist, auf einem Siliziumsubstrat 2 vergraben. Auf dem derart auf dem Siliziumsubstrat 2 vergrabenen Isolationsgebiet 1 werden in herkömmlicher Weise Wortleitungen 3, 4, 5 und 6 ausgebildet. Diese Wortleitungen werden daraufhin mit einer Hartmaske 7a, 7b, 7c und 7d und mit Seitenwandoxiden 8a, 8b, 8c, 8d, 8e, 8f, 8g und 8h abgedeckt. Diese Abdeckungstechnik gehört ebenso zum Stand der Technik wie das hierfür verwendete Material und erfordert deshalb vorliegend keine weitere Erläuterung. Die Dicke der Hartmaske 7a bis 7d ist so gewählt, daß sie bei der nachfolgend erläuterten SAS-Ätzung das Wortleitungs-Material bzw. - Polysilizium schützt.

Wie in Fig. 4 gezeigt, wird daraufhin auf der Hartmaske 7a bis 7d und den Seitenwandoxiden 8a bis 8h mittels der CVD(Chemical Vapor Deposition)-Technik ein Oxid bzw. Nitrid als Abstandshalter abgeschieden. Diese Oxid- bzw. Nitrid-Schicht schützt die Gate- bzw. Zellen-Poly-Seiten der Wortleitungen. Die Abstandshalter sind mit den Bezugsziffern 9a, 9b, 9c, 9d, 9e, 9f, 9g und 9h bezeichnet und erstrecken sich von den Seitenrändern der Hartmasken 7a bis 7d über die Seitenwandoxide 8a-8h bis zum Fuß der Wortleitungen 3 bis 6 auf das Isolationsgebiet 1.

Wie ebenfalls in Fig. 4 gezeigt, erfolgt daraufhin ein Ätzen der Abstandshalter mit den Bezugsziffern 9a, 9b, 9c, 9d, 9e, 9f, 9g und 9h, und dabei entstehen prozeßinhärent Abstandskanäle in dem Isolationsgebiet zwischen aneinandergrenzenden Wortleitungen 3, 4, 4, 5, und 5, 6. Diese Abstandskanäle sind mit den Bezugsziffern 10a, 10b und 10c bezeichnet.

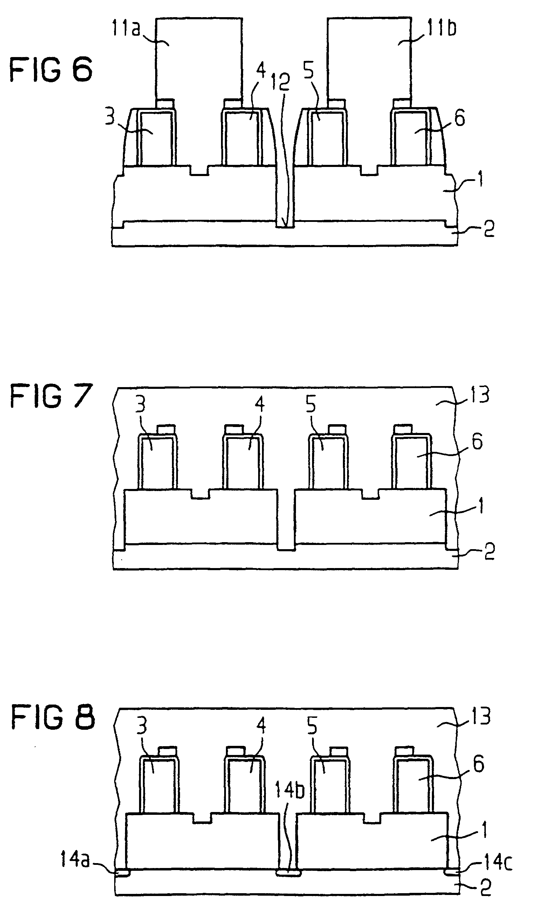

Als nächstes folgt, wie in Fig. 5 gezeigt, das Aufbringen einer SAS(Self Aligned Source) - lackmaske auf die Struktur von Fig. 4 derart, daß jeweils zwei benachbarte beschichtete Wortleitungen 3, 4 und 5, 6 auf den zueinander weisenden Abschnitten einschließlich des dazwischenliegenden Abstandskanals 10a bzw. 10c maskiert sind, während jeweils zwei dieser benachbarten maskierten Wortleitungspaare 3, 4 bzw. 5, 6 auf den zueinander weisenden Abschnitten unmaskiert belassen sind. Diese Lackmaske ist in Fig. 5 mit den Bezugsziffern 11a und 11b versehen.

Insbesondere deckt damit der Lackmaskenteil 11a jeweils die Hälfte der Hartmaske 7a und 7b bzw. 7c und 7d der Wortleitungen 3, 4 bzw. 5, 6 sowie deren aufeinanderzu weisenden Seitenwandoxide 8b, 8c bzw. 8f, 8h ab, und dieser Lackmaskenteil 11a erstreckt sich außerdem bis auf die Oberseite des Isolationsgebiets 1 zwischen den Wortleitungen 3, 4 bzw. 5, 6 und in die Abstandskanäle 10a und 10c hinein.

Wie in Fig. 6 gezeigt, erfolgt als nächstes ausgehend von der Struktur von Fig. 5 eine Belichtung der SAS-Lackmaske 11a, 11b. Wie ebenfalls in Fig. 6 gezeigt, erfolgt daraufhin ein anisotropes Ätzen sowie Überätzen der von der SAS-Lochmaske 11a, 11b nicht abgedeckten Bereiche des Isolationsgebiets 1 unter Absenkung der Sohle des nicht abgedeckten Abstandskanals 10b zwischen den beiden teilabgedeckten Wortleitungspaaren 3, 4 und 5, 6.

Durch diesen Ätzschritt wird die STI-Füllung in diesen Bereichen vollständig abgetragen. Zu bemerken ist, daß die Ätzung hierbei eine ausreichende Selektivität zu der Hartmaske 7a bis 7d und dem Abstandshalter 9a bis 9h sowie zum Siliciumsubstrat hat. Die Absenkung der Sohle des Abstandskanals 10b durch diese Ätzung erfolgt zumindest bis auf die Oberseite des Siliziumsubstrats 2, jedoch bevorzugt unter dieser Oberfläche, wie schematisch in Fig. 6 gezeigt und mit der Bezugsziffer 12 bezeichnet.

Hiermit ist die Strukturierung des Speicherzellen-Arrays abgeschlossen.

Folgend auf den in Fig. 6 gezeigten Ätzschritt wird die damit erhaltene Struktur von der Lackmaske 11a, 11b in an sich bekannter Weise befreit. Außerdem erfolgt bevorzugt eine an sich bekannte Nachbehandlung der Strukturoberfläche.

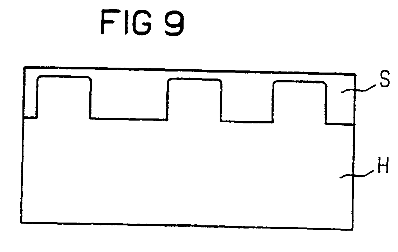

Wie in Fig. 7 und 8 gezeigt, schließt sich ein Source-Dotierungsprozeß an, wie im folgenden erläutert.

Wie in Fig. 7 gezeigt, wird zunächst eine PSG(mit Phosphor dotierte Glas)-Schicht auf die freigelegte Struktur gemäß Fig. 6 abgeschieden. Die PSG-Schicht ist mit der Bezugsziffer 13 bezeichnet und bedeckt, wie aus Fig. 7 hervorgeht, die gesamte Oberflächenstruktur des Speicherzellen-Arrays von Fig. 6.

Die Struktur gemäß Fig. 7 mit der PSG-Schicht 13 wird nunmehr mittels eines Ofenprozesses bzw. RTA getempert. Dabei diffundiert die Phosphordotierung der PSG-Schicht 13 in das freiliegende Siliziumsubstrat 2. In den übrigen Teilen der Struktur verhindert die abgeschiedene CVD-Oxid- bzw. Nitrid-Schicht eine derartige Eindiffusion. Die Eindiffusion der Phosphordotierung in das freiliegende Siliziumsubstrat ist in Fig. 8 mit den Bezugsziffern 14a, 14b und 14c bezeichnet.

Die PSG-Schicht 13 kann nunmehr mittels CMP gemäß Stand der Technik planarisiert werden und bildet damit gleichzeitig das Zwischenoxid zu der ersten Metallebene. Die PSG-Schicht 13 kann auf dem derart gebildeten Chip verbleiben, da bei sämtlichen nachfolgenden Prozessen kein nennenswertes thermisches Budget für eine weitere Ausdiffusion auftritt.

Als nächster Schritt schließt sich eine in der Zeichnung nicht näher gezeigte Kontaktlochätzung und -füllung an, welche Prozeßschritte ebenfalls zum Stand der Technik gehören. Da die Source auf dem Niveau einer üblichen Diffusion nach diesem Verfahren existiert, kann der zugehörige Kontakt wie jeder andere Diffusionskontakt behandelt und plaziert werden.

Schließlich erfolgt als letzter Verfahrensschritt die Metallisierung, welcher Schritt ebenfalls zum Stand der Technik gehört.

Fig. 9 zeigt einen Schnitt entlang der Linie A-A von Fig. 2 des fertiggestellten Source-Bereichs.

Obwohl die vorliegende Erfindung vorstehend anhand bevorzugter Ausführungsbeispiele beschrieben wurde, ist sie darauf nicht beschränkt, sondern auf vielfältige Art und Weise modifizierbar.

Beispielsweise kann in Abwandlung zu dem vorstehend erläuterten Temperungsschritt bei der Source-Dotierung (Fig. 7) alternativ das thermische Budget zum Eintreiben des Phosphors aus der PSG-Schicht 13 in das Siliziumsubstrat 2 auch mit Verfließprozessen des Zwischenoxids kombiniert werden.

## Patentansprüche

1. Verfahren zum Herstellen eines Speicherzellen-Arrays, insbesondere eines EPROM- bzw. EEPROM-Speicherzellen-Arrays, mit einem Siliziumsubstrat (2), auf dem Siliziumsubstrat (2) angeordneten Isolationsgebieten (1), und auf den Isolationsgebieten (1) angeordneten Wortleitungen (3 bis 6), mit den Schritten:
a) Vergraben der Isolationsgebiete (1) auf dem Siliziumsubstrat (2),
b) Ausbilden der Wortleitungen (3 bis 6) auf den Isolationsgebieten (1),
c) Abdecken der Wortleitungen (3 bis 6) mit einer Hartmaske (7a bis 7d) und Seitenwandoxiden (8a bis 8h),
d) CVD-Abscheiden von einen Material, vorzugsweise einem Oxid oder Nitrid, seitlich auf die Hartmaske (7a bis 7d) und auf die Seitenwandoxide (8a bis 8h) zur Festlegung von Abstandshaltern (9a bis 9h),
e) Erzeugen der Abstandshalter (9a bis 9h) unter Ausbildung von Abstandskanälen (10a, 10b, 10c) in den Isolationsgebieten (1) zwischen aneinandergrenzenden Wortleitungen (3 bis 6) durch Ätzen,
f) Aufbringen und Strukturieren einer Self Aligned Source-Lackmaske (11a, 11b) derart, daß jeweils zwei benachbarte beschichtete Wortleitungen (3, 4; 5, 6) bereichsweise einschließlich des zwischen diesen Wortleitungen liegenden Abstandskanals (10a, 10c) maskiert sind, während jeweils zwei benachbarte maskierte Wortleitungen (4, 5) der maskierten Wortleitungspaare (3, 4; 5, 6) bereichsweise einschließlich des zwischen diesen Wortleitungen liegenden Abstandskanals (10b) unmaskiert bleiben,
g) Belichten der SAS-Lackmaske (11a, 11b),
h) anisotropes Ätzen der von der SAS-Lackmaske (11a, 11b) nicht abgedeckten Bereiche der Isolationsgebiete (1) unter Absenkung der Sohle (12) der nicht abgedeckten Abstandskanäle (10b) bis zumindest auf die Oberfläche des Siliziumsubstrats (2), und
i) Entfernen der SAS-Lackmaske (11a, 11b) zum Freilegen der gewonnenen Struktur,
**gekennzeichnet durch** die Schritte:
a') Anwenden der Shallow Trench Isolation-Technik zum Vergraben der Isolationsgebiete (1) auf dem Siliziumsubstrat (2),
j) Abscheiden einer PSG Schicht (13) auf die freigelegte Struktur, und
k) Tempern der **dadurch** gewonnenen Struktur zum Diffundieren der Phosphordotierung aus der PSG-Schicht (13) in das freigelegte Siliziumsubstrat (2) als Source-Dotierungsprozeßschritt.

2. Verfahren nach Anspruch 1, **dadurch gekennzeichnet, daß** nach dem Schritt i) und vor dem Schritt j) ein Nachbehandlungsschritt für die freigelegte Struktur folgt.

3. Verfahren nach Anspruch 1 oder 2, **dadurch gekennzeichnet, daß** der Ätzschritt h) zusätzlich ein Überätzen umfaßt.

4. Verfahren nach Anspruch 1, 2 oder 3, **dadurch gekennzeichnet, daß** im Ätzschritt h) die Hartmaske und das CVD-Oxid bzw. -Nitrid gedünnt werden.

5. Verfahren nach Anspruch 1, **dadurch gekennzeichnet, daß** der Temperschritt k) in einem Ofen durchgeführt wird.

6. Verfahren nach Anspruch 1, **dadurch gekennzeichnet, daß** der Temperschritt k) mittels RTA erfolgt.

7. Verfahren nach Anspruch 1, 5 oder 6, **dadurch gekennzeichnet, daß** auf den Schritt k) ein Schritt zum Planarisieren der gewonnenen Struktur folgt.

8. Verfahren nach Anspruch 7, **dadurch gekennzeichnet, daß** das Planarisieren mittels CMP erfolgt.

9. Verfahren nach Anspruch 7 oder 8, **dadurch gekennzeichnet, daß** auf das Planarisieren ein Prozeß zur Kontaktlochätzung und -füllung und zur Metallisierung folgt.

## Claims

1. Method for fabricating a memory cell array, in particular an EPROM or EEPROM memory cell array, having a silicon substrate (2), insulation zones (1) arranged on the silicon substrate (2), and word lines (3 to 6) arranged on the insulation zones (1), having the following steps:
a) burying of the insulation zones (1) on the silicon substrate (2),
b) formation of the word lines (3 to 6) on the insulation zones (1),
c) covering of the word lines (3 to 6) with a hard mask (7a to 7d) and side wall oxides (8a to 8h),
d) CVD deposition of a material, preferably an oxide or nitride, laterally onto the hard mask (7a to 7d) and onto the side wall oxides (8a to 8h) in order to define spacers (9a to 9h),
e) production of the spacers (9a to 9h) to form spacer channels (10a, 10b, 10c) in the insulation zones (1) between adjoining word lines (3 to 6) by etching,
f) application and patterning of a Self Aligned Source resist mask (11a, 11b) in such a way that each two adjacent coated word lines (3, 4; 5, 6) are masked in regions, including the spacer channel (10a, 10c) located between these word lines, while each two adjacent masked word lines (4, 5) of the masked word line pairs (3, 4; 5, 6) remain unmasked in regions, including the spacer channel (10b) lying between these word lines,
g) exposure of the SAS resist mask (11a, 11b),
h) anisotropic etching of those regions of the insulation zones (1) which are not covered by the SAS resist mask (11a, 11b), with the bottom (12) of the uncovered spacer channels (10b) being lowered down at least to the surface of the silicon substrate (2), and
i) removal of the SAS resist mask (11a, 11b) in order to uncover the resultant structure,
**characterized by** the following steps:
a') application of the Shallow Trench Isolation technology for burying the insulation zones (1) on the silicon substrate (2),
j) deposition of a PSG layer (13) onto the uncovered structure, and
k) heat treatment of the resultant structure in order to diffuse the phosphorus doping from the PSG layer (13) into the uncovered silicon substrate (2) as a source doping process step.

2. Method according to Claim 1, **characterized in that** an aftertreatment step for the uncovered structure takes place after step i) and before step j).

3. Method according to Claim 1 or 2, **characterized in that** the etching step h) additionally comprises overetching.

4. Method according to Claim 1, 2 or 3, **characterized in that**, in the etching step h), the hard mask and the CVD oxide or nitride are thinned.

5. Method according to Claim 1, **characterized in that** the heat treatment step k) is carried out in a furnace.

6. Method according to Claim 1, **characterized in that** the heat treatment step k) is effected by means of RTA.

7. Method according to Claim 1, 5 or 6, **characterized in that** the step k) is followed by a step for planarizing the resultant structure.

8. Method according to Claim 7, **characterized in that** the planarization is effected by means of CMP.

9. Method according to Claim 7 or 8, **characterized in that** the planarization is followed by a process for contact hole etching and filling and for metallization.

## Revendications

1. Procédé de production d'un réseau de cellules de mémoire, notamment d'un réseau de cellules de mémoire EPROM ou EEPROM comprenant un substrat (2) de silicium, des zones (1) d'isolement disposées sur le substrat (2) de silicium et des lignes (3 à 6) de mots disposées sur les zones (1) d'isolement, comprenant les stades qui consistent :
a) à enterrer les zones (1) d'isolement sur le substrat (2) en silicium,
b) à constituer les lignes (3 à 6) de mots sur les zones (1) d'isolement,
c) à recouvrir les lignes (3 à 6) de mots d'un masque (7a à 7d) dur et d'oxydes (8a à 8h) de paroi latérale,
d) à déposer par CVD, une matière, de préférence un oxyde ou un nitrure, latéralement sur le masque (7a à 7d) dur et sur les oxydes (8a à 8h) de paroi latérale pour la fixation d'espaceurs (9a à 9h),
e) à produire les espaceurs (9a à 9h) en constituant des canaux 10a, 10b, 10c) de mise à distance dans les zones (1) d'isolement entre des lignes (3 à 6) de mots voisines en procédant par attaque,
f) à déposer et à structurer, un masque (11a, 11 b) de vernis de source Self Aligned de façon à ce que respectivement deux lignes (3, 4, 5, 6) de mots, revêtues et voisines, soient masquées par partie y compris le canal (10a, 10c) de mise à distance se trouvant entre ces lignes de mots, tandis que respectivement deux lignes (4, 5) de mots, masquées et voisines, des paires (3, 4, 5, 6) de lignes de mots masquées soient démasquées par partie y compris le canal (10b) de mise à distance se trouvant entre ces lignes de mots,
g) à exposer à un rayonnement le masque (11a, 11 b) de vernis SAS,
h) à attaquer de façon anisotrope les parties, non revêtues du masque (11a, 11b) de vernis SAS, des zones (1) d'isolement en abaissant le fond (12) des canaux (10b) de mise à distance non revêtus jusqu'à au moins la surface du substrat (2) de silicium,
i) à éliminer le masque (11a, 11b) de vernis SAS, pour dégager la structure obtenue,
**caractérisé par** les stades :
a') utilisation de la technique Shallow Trench Isolation pour enterrer les zones (1) d'isolement sur le substrat (2) en silicium,
j) dépôt d'une couche (13) de PSG, sur la structure dégagée,
k) recuit de la structure ainsi obtenue par diffusion de dopage de phosphore hors de la couche (13) PSG dans le substrat (2) dégagé en silicium comme stade opératoire de dopage de source,

2. Procédé suivant la revendication 1, **caractérisé en ce qu'**après le stade i) et avant le stade j) vient un stade de post-traitement de la structure dégagée.

3. Procédé suivant la revendication 1 ou 2, **caractérisé en ce que** le stade h) d'attaque, comprend en outre, une sur-attaque.

4. Procédé suivant la revendication 1, 2 ou 3, **caractérisé en ce qu'**au stade h) d'attaque on amincit le masque dur et l'oxyde ou le nitrure CVD.

5. Procédé suivant la revendication 1, **caractérisé en ce que** l'on effectue le stade k) de recuit dans four.

6. Procédé suivant la revendication 1, **caractérisé en ce que** l'on effectue le stade k) de recuit au moyen de RTA.

7. Procédé suivant la revendication 1, 5 ou 6, **caractérisé en ce qu'**après le stade k) vient un stade de planarisation de la structure obtenue.

8. Procédé suivant la revendication 7, **caractérisé en ce que** l'on effectue la planarisation au moyen de CMP.

9. Procédé suivant la revendication 7ou 8, **caractérisé en ce qu'**après la planarisation vient une opération d'attaque et de remplissage de trous de contact et de métallisation.
